# FASCICULE DE BREVET EUROPEEN

(11) **EP 1 030 418 B1**
(45) Date de publication et mention de la délivrance du brevet: **13.10.2004**
(21) Numéro de dépôt: 00400411.5
(22) Date de dépôt: 11.02.2000
(51) Int. Cl.: H01S 5/14

(54) **Réflecteur optique et source laser à cavité externe incorporant un tel réflecteur**
Optischer Reflektor und dessen Benutzung in einem Laser mit externem Resonator
Optical reflector and external cavity laser including such a reflector

(30) Priorité: 15.02.1999 FR 9901788
(43) Date de publication de la demande: 23.08.2000
(73) Titulaire: NETTEST PHOTONICS, 78340 Les Clayes Sous Bois (FR)
(72) Inventeur: Lefevre, Hervé, 75014 Paris (FR)
(74) Mandataire: Michelet, Alain

(56) Documents cités:
- EP-A- 0 030 891
- FR-A- 2 724 496
- PATENT ABSTRACTS OF JAPAN vol. 006, no. 185 (E-132), 21 septembre 1982 (1982-09-21) & JP 57 099793 A (TOMIJIMA TAKUMI), 21 juin 1982 (1982-06-21)
- BASIEV T.T., FEDIN A.V., GAVRILOV A.V., SMETANIN S.N.: "Powerful single mode Nd Lasers with self phase conjugation" PROCEEDINGS OF THE INTERNATIONAL CONFERENCE ON LASERS '98, 7 - 11 décembre 1998, pages 1044-1047, XP000852817 Tucson, AZ

## Description

La présente invention concerne un réflecteur optique destiné à recevoir un faisceau d'entrée et émettant un faisceau de sortie parallèle et de sens inverse, éventuellement superposé au faisceau d'entrée.

Il est bien connu que l'alignement des composants optiques est déterminant pour la qualité des appareils qui les comportent. C'est la raison pour laquelle tout auto-alignement, c'est-à-dire tout montage dans lequel les propriétés du flux lumineux sortant sont peu sensibles à l'orientation ou à la position d'un ou de plusieurs composants, est recherché.

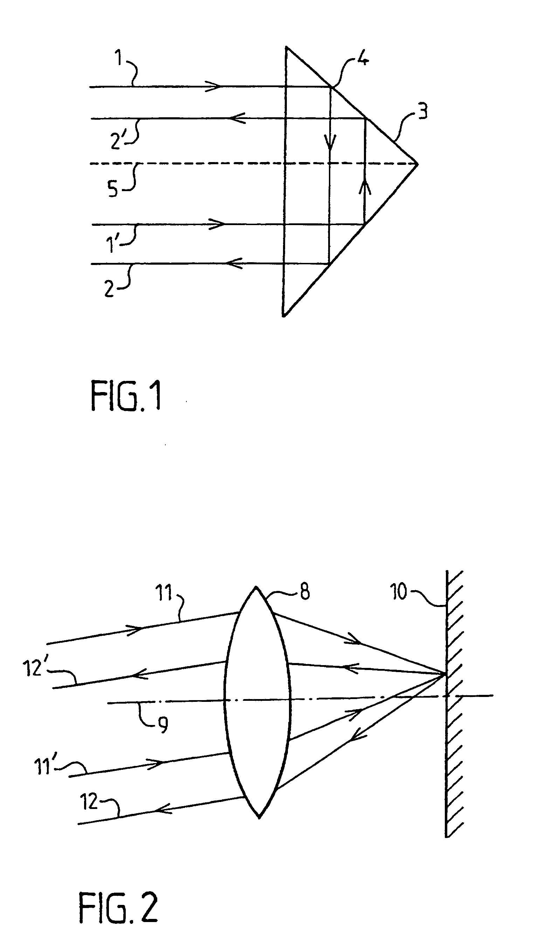

Parmi les systèmes rétroréfléchissants auto-alignés connus de longue date, on citera à titre d'exemple le coin de cube illustré sur la figure 1 avec lequel un faisceau incident 1, 1' sur un trièdre orthogonal réfléchissant 3 produit un faisceau sortant 2, 2' parallèle, quel que soit l'angle d'incidence par rapport à la diagonale 5 du cube et la position du point d'incidence 4.

On connaît également le montage dit « oeil-de-chat » qui est composé d'un système optique convergent 8 d'axe optique 9, dans le plan focal duquel est placé un miroir 10 approximativement perpendiculaire à l'axe 9. Un faisceau incident collimaté 11, 11' converge sur le miroir 10, y est réfléchi et ensuite diverge en retour sur le système optique 8 qui produit un faisceau de sortie 12, 12' également collimaté et parallèle à 11. Un tel oeil-de-chat est représenté sur la figure 2.

Ces deux systèmes préalablement décrits offrent un auto-alignement de la direction du faisceau de sortie 2, 2' et 12, 12' sur celui d'entrée respectivement 1,1' et 11, 11' dans deux dimensions, c'est-à-dire dans tous les plans parallèles à la direction des faisceaux d'entrée. Dans certains systèmes, on cherchera à réaliser l'auto-alignement dans une seule dimension, on utilisera alors, soit un dièdre orthogonal à la place du trièdre de la figure 1, soit un oeil-de-chat cylindrique, c'est-à-dire une lentille ou un système optique cylindrique à la place du système optique sphérique 8 dans le cas de la figure 2. Le dièdre assure l'auto-alignement dans le plan perpendiculaire à son arête et l'oeil de chat cylindrique dans le plan perpendiculaire à la génératrice de sa lentille cylindrique. Dans le plan parallèle, ces deux derniers systèmes se comportent comme un miroir.

On connaît par ailleurs des composants ou dispositifs optiques séparateurs auto-alignés qui produisent à partir d'un faisceau incident unique, deux faisceaux émergents parallèles entre eux. Ce peut être par exemple un périscope ou une lame à faces parallèles dont une face est partiellement métallisée, de façon à modifier son coefficient de réflexion sur une partie de sa surface.

Les dièdres et les trièdres classiques ne permettent cependant qu'une réflexion totale du faisceau alors que, dans certaines applications, on désire avoir une deuxième porte de sortie partielle en plus de la première rétroréfléchie.

L'invention met en oeuvre un dispositif interférométrique du type interféromètre de Sagnac, susceptible de produire deux faisceaux qualifiés respectivement de faisceaux réciproque et non réciproque en fonction du nombre de réflexions subies par chacun des deux faisceaux interférant pour composer les faisceaux de sortie.

Les interféromètres de Sagnac sont bien connus, par exemple du document EP 0 030 891 A. Ils sont constitués d'un séparateur de faisceaux et d'un anneau, c'est-à-dire d'un chemin optique fermé commençant et se terminant au niveau du séparateur de faisceau.

Cet anneau et le séparateur de faisceaux sont disposés de telle sorte qu'un faisceau entrant est séparé en deux faisceaux secondaires circulant chacun dans l'anneau respectivement dans des sens opposés.

Ainsi, au retour, les ondes correspondantes à chacun de ces faisceaux interfèrent et produisent deux faisceaux de sortie.

Cet anneau est souvent constitué par trois miroirs indépendants et il est connu que l'on produit ainsi une sortie réciproque pour laquelle les ondes interférentes ont subi le même nombre de réflexions au cours de leur circuit dans l'anneau et une sortie non réciproque pour laquelle ces ondes ont subi un nombre de réflexions différentes.

On appelle « teinte plate» l'état d'interférence obtenu quand l'orientation des miroirs est réglée pour étaler les franges d'interférences jusqu'à les supprimer.

Le but de l'invention est de proposer un tel interféromètre de Sagnac constituant un réflecteur optique, qui bénéficie des avantages d'un dispositif réflecteur auto-aligné et soit donc particulièrement simple à régler et dont la stabilité dans le temps soit améliorée.

C'est un autre avantage de l'invention que de permettre la réalisation d'un laser accordable en longueur d'onde, éventuellement de manière continue, qui permette une extraction du faisceau lumineux de sortie dans des conditions optimisées, avec des pertes minimum.

Dans un autre mode de réalisation de l'invention, il est possible d'obtenir un laser dont le bruit de fond résultant de l'émission ASE (Amplified Spontaneous Emission) soit filtré spectralement et qui présente donc une meilleure efficacité à la longueur d'onde d'émission du laser.

L'invention telle que définie dans la revendication 1 concerne donc un réflecteur optique recevant un faisceau d'entrée, émettant un faisceau de sortie réciproque rétroréfléchi et comportant un séparateur de faisceaux produisant un premier faisceau et un deuxième faisceau secondaires, parallèles l'un à l'autre et des moyens réfléchissants renvoyant chacun des faisceaux secondaires vers le séparateur de faisceaux et formant un interféromètre de Sagnac.

Selon l'invention, que lesdits moyens réfléchissants sont un réflecteur total auto-aligné et le séparateur de faisceaux est auto-aligné. Les modes particuliers de réalisation de l'invention sont définis dans les revendications dépendantes.

De manière préférée, dans différents modes de réalisation présentant chacun leurs avantages respectifs :
- le réflecteur total auto-aligné est à une dimension ;
- le réflecteur total auto-aligné est à deux dimensions ;
- le séparateur de faisceaux est déséquilibré en énergie, ledit réflecteur émettant ainsi un faisceau de sortie non réciproque ;
- le réflecteur optique comporte un réseau de diffraction formant avec le réflecteur total, un système de Littman-Metcalf ;
- le réseau de diffraction est placé entre le séparateur de faisceaux et le réflecteur total.

L'invention concerne également une source laser à cavité externe comprenant un milieu amplificateur et un dispositif dispersif rétroréfléchissant comportant un réflecteur optique formé par un interféromètre de Sagnac avec un réflecteur total et un réseau en configuration de Littman-Metcalf.

Avantageusement :
- le milieu amplificateur est un guide d'onde et il est associé à une optique de collimation rendant collimaté le faisceau qu'il produit ;
- la face externe du guide d'onde est totalement réfléchissante et le faisceau non réciproque est le seul faisceau émis par la source ;
- le dièdre est mobile en rotation de façon à permettre la variation de la longueur d'onde ;
- le dièdre est mobile en rotation et en translation de façon à assurer la variation continue de la longueur d'onde ;
- la source laser comporte plusieurs guides amplificateurs angulairement décalés par rapport au dispositif dispersif rétroréfléchissant et permettant l'émission de la source à plusieurs longueurs d'onde.

L'invention sera décrite plus en détail en référence aux dessins annexés dans lesquels :
- la figure 1 représente un coin de cube constituant un dispositif auto-aligné à deux dimensions de l'art antérieur ;
- la figure 2 représente un oeil-de-chat constituant un dispositif auto-aligné à deux dimensions de l'art antérieur ;
- la figure 3 est un réflecteur optique selon l'invention ;
- la figure 4 est la vue de côté d'un laser selon l'invention ;
- la figure 5 est la vue de dessus d'un laser selon l'invention ;
- la figure 6 représente une lame à faces parallèles utilisable comme séparateur de faisceaux auto-aligné.

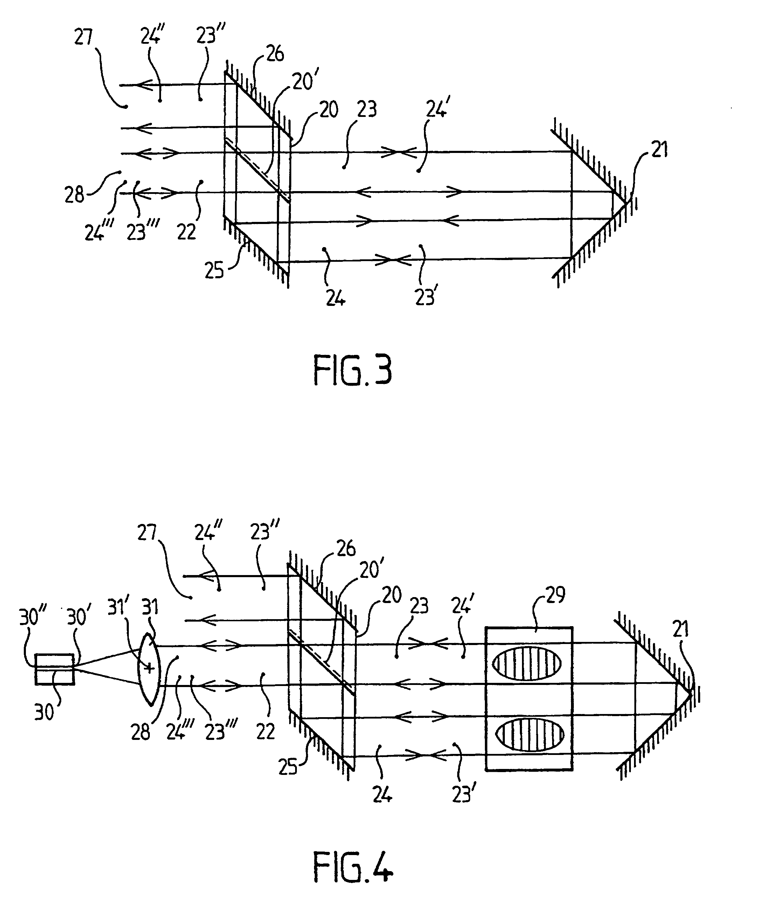

Le réflecteur optique représenté sur la figure 3 comporte un séparateur de faisceaux 20 et un réflecteur total auto-aligné 21.

Le faisceau d'entrée 22 est divisé par le séparateur auto-aligné 20 en deux faisceaux parallèles : un premier faisceau séparé 23 et un deuxième faisceau séparé 24 se propageant en espace libre. Le premier faisceau séparé 23 est réfléchi par le réflecteur auto-aligné 21 et forme un faisceau séparé réfléchi 23' qui est dirigé vers le séparateur de faisceaux 20, qui le réfléchit partiellement et le transmet partiellement. Le faisceau transmis 23" est renvoyé parallèlement et dans le sens contraire au faisceau d'entrée 22.

Le faisceau réfléchi par le séparateur 20 est un faisceau 23''' superposé et de sens contraire au faisceau d'entrée 22. De manière analogue, le faisceau 24 produit à partir du faisceau d'entrée 22 par réflexion sur le séparateur 20, est lui-même réfléchi par le réflecteur total 21 et forme le faisceau 24' qui est renvoyé sur le séparateur 20 qui le divise en deux faisceaux, respectivement 24'' et 24''', qui interfèrent avec les faisceaux 23'' et 23''' produisant ainsi deux faisceaux de sortie, respectivement 27 et 28, parallèles entre eux. Le faisceau 28 est produit par l'interférence des faisceaux 23''' et 24''' qui ont chacun subi une seule réflexion sur le séparateur 20. Ce faisceau 28, dit réciproque, est superposé au faisceau d'entrée 22 et de sens contraire.

Au contraire, le faisceau 27 est produit par les interférences du faisceau 23" qui n'a subi aucune réflexion sur le séparateur 20 et du faisceau 24" qui a subi deux réflexions sur ce même séparateur. Cette différence de nombre de réflexions subies par chacun des faisceaux introduit un déphasage de π radian et la sortie 27 est dite sortie non réciproque.

Le dispositif de l'invention constitue donc un réflecteur optique qui, à partir d'un faisceau d'entrée 22, produit deux faisceaux, respectivement réciproque 28 et non réciproque 27, parallèles entre eux et auto-alignés sur le faisceau d'entrée. Le faisceau réciproque 28 est superposé au faisceau d'entrée 22 alors que le faisceau non réciproque 27 est décalé.

La mise en oeuvre du réflecteur total auto-aligné 21 facilite le réglage du dispositif et améliore donc son rendement.

Lorsque le séparateur 20 est un séparateur 50/50, l'intensité des faisceaux séparés 23 et 24 est égale et lors de leur recombinaison, l'ensemble de l'énergie se trouve regroupée sur la sortie réciproque en un faisceau 28, alors que le faisceau 27, en raison du déphasage entre les ondes des faisceaux 24" et 23", a une énergie nulle, c'est-à-dire qu'il n'existe pas.

Il est possible d'utiliser un séparateur 20 déséquilibré en énergie, permettant la répartition de l'énergie incidente entre les deux faisceaux de sortie 27 et 28. R et T étant respectivement les coefficients de réflexion et de transmission en énergie du séparateur 20, on trouve à la porte non réciproque (1 - 4 RT) de l'énergie entrante. Par exemple avec R = 90 % et T = 10 %, on obtient (1 - 4 RT) = 64 % à la porte non réciproque.

Le séparateur auto-aligné 20 peut avantageusement être un séparateur périscopique composé d'une interface séparatrice 20' et de deux miroirs 25 et 26 qui lui sont parallèles.

L'utilisation d'un réseau de diffraction 29, sur le trajet du faisceau lumineux permet d'étaler géométriquement le spectre des flux lumineux en sortie et éventuellement d'en sélectionner une partie.

Ce réseau de diffraction 29 est avantageusement placé dans une configuration de Littman-Metcalf entre le séparateur de faisceaux auto-aligné 20 et le réflecteur total auto-aligné 21.

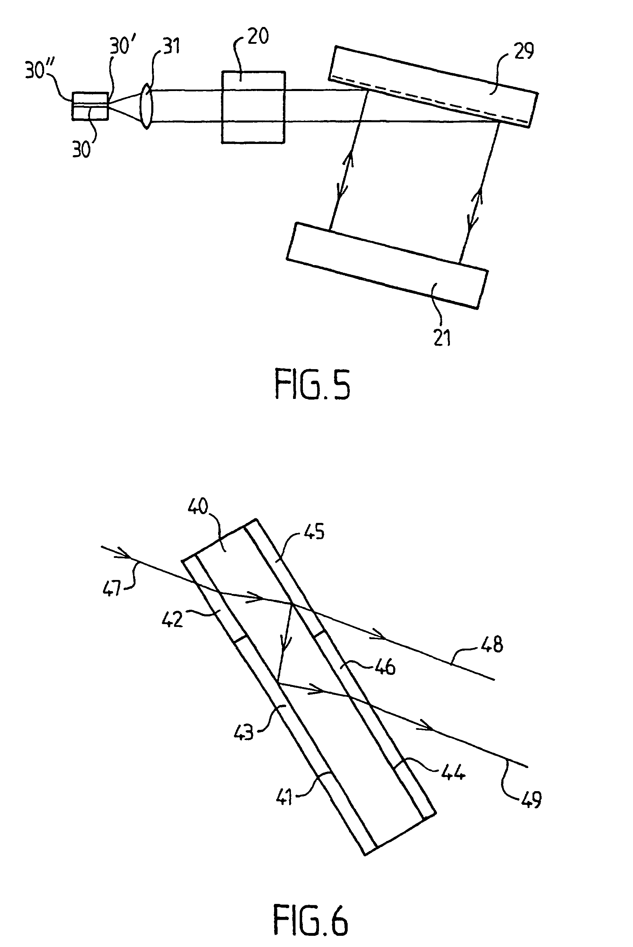

Les figures 4 et 5 représentent respectivement la vue de côté et la vue de dessus d'une source laser selon l'invention et, sur cette figure, les éléments communs à ceux de la figure 3 ont été maintenus avec les mêmes références numériques.

Un milieu amplificateur, de préférence un guide d'onde amplificateur 30, dont l'extrémité interne 30' est placée au foyer de la lentille de collimation 31 de centre 31', génère le faisceau d'entrée collimaté 22. La face externe 30" de ce guide d'onde amplificateur 30 est entièrement réfléchissante, et le séparateur 20 est déséquilibré. Ainsi, on forme une cavité laser entre la face entièrement réfléchissante 30" et le réflecteur total auto-aligné 21 au travers de la sortie réciproque où le faisceau 28 est superposé au faisceau d'entrée 22. La sortie non réciproque 27 décalée constitue la sortie du laser et forme donc le faisceau émis.

La présence d'un réseau 29 dans la configuration de Littman-Metcalf avec le réflecteur total auto-aligné 21, dans cette source laser, permet, à la sortie non réciproque 27, de filtrer spectralement le fond continu parasite de rayonnement ASE et donc d'isoler la raie d'émission du laser.

Le réglage en longueur d'onde d'émission peut être obtenu soit par rotation du réseau, soit par rotation du réflecteur total 21, soit encore par rotation de l'ensemble formé par le réseau 29 et le réflecteur total 21, et le faisceau non réciproque filtré 27 reste stable car il est parallèle au faisceau d'entrée. Ce faisceau peut être éventuellement couplé dans une fibre optique monomode.

Un mouvement coordonné en rotation et/ou en translation du dièdre réflecteur 21 avec le mouvement du réseau 29 permet de réaliser une source laser à accordabilité continue. Un tel mouvement coordonné est par exemple décrit dans le brevet français FR-2.724.496.

Une telle source laser peut aussi être réalisée avec plusieurs milieux amplificateurs ou guides d'onde 30 placés dans le plan focal de la lentille 31. On constitue ainsi une source multilongueurs d'onde formée par la superposition de plusieurs flux laser, chacun correspondant à un guide d'onde et ayant une longueur d'onde dépendant de l'angle sous lequel ce guide d'onde est vu depuis le dispositif dispersif réfléchissant.

Les figures et la description ont été faites en utilisant comme réflecteur auto-aligné, un coin de cube ou un dièdre, des résultats analogues peuvent être obtenus en utilisant un oeil-de-chat. Le coin de cube et le dièdre peuvent être constitués de miroirs plans mais aussi fabriqués à partir d'un trièdre plein ou bien d'un prisme isocèle rectangle fonctionnant en réflexion interne totale.

Il a été mentionné plus haut que le séparateur auto-aligné 20 peut être un séparateur périscopique. Il peut être aussi une lame à faces parallèles. Une telle lame 40 est représentée sur la figure 6.

Sa face d'entrée 41 est partiellement recouverte d'un traitement antireflet 42 et d'un traitement entièrement réfléchissant 43.

Sa face de sortie 44 est partiellement recouverte d'un traitement partiellement réfléchissant 45 et sur une autre zone, d'un traitement antireflet 46.

Ainsi, un faisceau incident 47 est partiellement transmis en 48 et le flux restant est transmis, après deux réflexions en 49. On obtient donc ainsi la fonction voulue.

## Revendications

1. Réflecteur optique recevant un faisceau d'entrée (22), émettant un faisceau de sortie réciproque (28) rétroréfléchi et comportant un séparateur (20) de faisceaux produisant un premier faisceau (23) et un deuxième faisceau (24) secondaires, parallèles l'un à l'autre et des moyens réfléchissants (21) renvoyant chacun des faisceaux secondaires vers le séparateur de faisceaux et formant un interféromètre de Sagnac, dont lesdits moyens réfléchissants sont un réflecteur total auto-aligné (21) et que le séparateur (20) de faisceaux est auto-aligné.

2. Réflecteur optique selon la revendication 1, **caractérisé en ce que** le réflecteur total auto-aligné (21) est à deux dimensions.

3. Réflecteur optique selon la revendication 1, **caractérisé en ce que** le réflecteur total auto-aligné (21) est à une dimension.

4. Réflecteur optique selon l'une quelconque des revendications 1 à 3, **caractérisé en ce que** le séparateur de faisceaux (20) a des coefficients de réflexion et de transmission en énergie non égaux pour produire ainsi un faisceau de sortie non réciproque.

5. Réflecteur optique selon l'une quelconque des revendications 2 à 4, **caractérisé en ce qu'**il comporte un réseau de diffraction formant avec le réflecteur total, un système de Littman-Metcalf.

6. Réflecteur optique selon la revendication 5, **caractérisé en ce que** le réseau de diffraction est placé entre le séparateur de faisceaux (20) et le réflecteur total (21).

7. Source laser à cavité externe comprenant un milieu amplificateur et un dispositif dispersif rétroréfléchissant, **caractérisée en ce que** le dispositif dispersif rétroréfléchissant est conforme à l'une quelconque des revendications 5 ou 6.

8. Source laser à cavité externe selon la revendication 7, **caractérisée en ce que** le milieu amplificateur est un guide d'onde et qu'il est associé à une optique de collimation rendant collimaté le faisceau qu'il produit.

9. Source laser à cavité externe selon la revendication 8, **caractérisée en ce que** la face externe du guide d'onde est totalement réfléchissante et que le faisceau non réciproque (27) est le seul faisceau émis par la source.

10. Source laser à cavité externe selon l'une quelconque des revendications 7 à 9, **caractérisée en ce que** le réflecteur total auto-aligné est un dièdre et que le dièdre est mobile en rotation de façon à permettre la variation de la longueur d'onde.

11. Source laser à cavité externe selon la revendication 10, **caractérisée en ce que** le dièdre est mobile en rotation et en translation de façon à assurer la variation continue de la longueur d'onde.

12. Source laser à cavité externe selon l'une quelconque des revendications 8 à 10, **caractérisée en ce qu'**elle comporte plusieurs guides amplificateurs angulairement décalés par rapport au dispositif dispersif rétroréfléchissant et permettant l'émission de la source à plusieurs longueurs d'onde.

## Patentansprüche

1. Optischer Reflektor, welcher einen Eingangsstrahl (22) empfängt, einen reziproken Ausgangsstrahl (28) reflektierend abgibt und welcher aufweist einen Strahlenseparator (20), welcher einen ersten sekundären Strahl (23) und einen zweiten sekundären Strahl (24) generiert, welche parallel zueinander sind, und reflektierende Mittel (21), welche jeweils einige sekundäre Strahlen zum Strahlenseparator senden und ein Sagnac-Interferometer bilden, wobei die genannten reflektierenden Mittel ein selbstausgerichteter Totalreflektor (21) sind und der Strahlenseparator (20) selbstausrichtend ist.

2. Optischer Reflektor nach Anspruch 1, **dadurch gekennzeichnet, dass** der selbstausrichtende Totalreflektor (21) zweidimensional ist.

3. Optischer Reflektor nach Anspruch 1, **dadurch gekennzeichnet, dass** der selbstausrichtende Totalreflektor (21) eindimensional ist.

4. Optischer Reflektor nach einem der Ansprüche 1 bis 3, **dadurch gekennzeichnet, dass** der Strahlenseparator (20) unterschiedliche Reflexionskoeffizienten und Energieübertragungskoeffizienten hat, um einen nicht reziproken Ausgangsstrahl zu generieren.

5. Optischer Reflektor nach einem der Ansprüche 2 bis 4, **dadurch gekennzeichnet, dass** der Reflektor ein Diffraktionsnetz aufweist, welches mit dem totalen Reflektor ein Littman-Metcalf-System bildet.

6. Optischer Reflektor nach Anspruch 5, **dadurch gekennzeichnet, dass** das Diffraktionsnetz zwischen dem Strahlenseparator (20) und dem Totalreflektor (21) angeordnet ist.

7. Laserquelle mit externem Resonator, mit einem Verstärkermedium und einer retroreflektierenden Streuvorrichtung, **dadurch gekennzeichnet, dass** die retroreflektierende Streuvorrichtung einem der Ansprüche 5 oder 6 entspricht.

8. Laserquelle mit externem Resonator nach Anspruch 7, **dadurch gekennzeichnet, dass** das Verstärkermedium ein Wellenleiter ist und an eine Kollimatoroptik angeschlossen ist, welche den erzeugten Strahl kollimiert wiedergibt.

9. Laserquelle mit externem Resonator nach Anspruch 8, **dadurch gekennzeichnet, dass** die Außenseite des Wellenleiters totalreflektierend ist und dass der nichtreziproke Strahl (27) den einzigen von der Quelle emittierten Strahl darstellt.

10. Laserquelle mit externem Resonator nach einem der Ansprüche 7 bis 9, **dadurch gekennzeichnet, dass** der selbstausrichtende Totalreflektor ein Winkelreflektor ist und dass der Winkelreflektor rotationsmobil ist, um die Änderung der Wellenlänge zu ermöglichen.

11. Laserquelle mit externem Resonator nach Anspruch 10, **dadurch gekennzeichnet, dass** der Winkelreflektor rotations- und translationsmobil ist, um die stufenlose Änderung der Wellenlänge zu ermöglichen.

12. Laserquelle mit externem Resonator nach einem der Ansprüche 7 bis 9, **dadurch gekennzeichnet, dass** die Laserquelle mehrere zur retroreflektierenden Streuvorrichtung im Winkel versetzte Verstärkerleiter aufweist und Emissionen der Quelle mit mehreren Wellenlängen ermöglicht.

## Claims

1. An optical reflector receiving an input beam (22), transmitting a retroreflected reciprocal output beam (28) and comprising a beam splitter (20) giving a first secondary beam (23) and a second secondary beam (24), parallel to one another as well as retroreflecting means (21) each redirecting secondary beams toward the beam splitter and forming a Sagnac interferometer in which the said reflecting means are a self-aligned total reflector (21) and the beam splitter (20) is self-aligned.

2. An optical reflector according to claim 1, **characterised in that** the self-aligned total reflector (21) is bidimensional.

3. An optical reflector according to claim 1, **characterised in that** the self-aligned total reflector (21) is unidimensional.

4. An optical reflector according to any one of claims 1 to 3, **characterised in that** the beam splitter (20) has energy reflection and transmission coefficients unbalanced, to produce thus a non-reciprocal output beam.

5. An optical reflector according to any one of claims 2 to 4, **characterised in that** it comprises a diffraction grating forming with the total reflector a Littman-Metcalf system.

6. An optical reflector according to claim 5, **characterised in that** the diffraction grating is located between the beam splitter (20) and the total reflector (21).

7. A laser source with external cavity comprising an amplifier medium and a retroreflecting-dispersing device, **characterised in that** the retroreflecting-dispersing device is according to claims 5 or 6.

8. A laser source with external cavity according to claim 7, **characterised in that** the amplifier medium is a wave guide and it is combined with collimation optics that collimate the beam thereby produced.

9. A laser source with external cavity according to claim 8, **characterised in that** the external face of the wave guide is totally reflecting and the non reciprocal beam (27) is the single beam transmitted by the source.

10. A laser source with external cavity according to any one of claims 7 to 9, **characterised in that** the self-aligned total reflector is a dihedron and the dihedron is mobile in rotation to enable the variation of the wavelength.

11. A laser source with external cavity according to claim 10, **characterised in that** the dihedron is mobile in rotation and in translation to enable continuous variation of the wavelength.

12. A laser source with external cavity according to any one of claims 8 to 10, **characterised in that** it comprises several amplifier guides that are offset angularly with respect to the retroreflecting-dispersing device and enabling the transmission of the source over several wavelengths.
